# DEMANDE DE BREVET EUROPEEN

(11) **EP 4 047 107 A1**
(43) Date de publication de la demande: **24.08.2022**
(21) Numéro de dépôt: 21158411.5
(22) Date de dépôt: 22.02.2021
(51) Int. Cl.: C23C 14/02, C23C 14/06, C23C 14/08, C23C 14/16, C23C 14/34, C23C 14/58, C23C 16/30, C23C 16/455, C23C 16/56, G04B 37/22, G04B 45/00

(54) **PROCÉDÉ DE DÉPÔT D'UNE MATIÈRE RARE EN COUCHE MINCE SUR UNE PIÈCE D HABILLAGE D HORLOGERIE OU DE BIJOUTERIE ET PIÈCE D HABILLAGE OBTENUE PAR CE PROCÉDÉ**

(71) Demandeur: The Swatch Group Research and Development Ltd, 2074 Marin (CH)
(72) Inventeur: WILLEMIN, Michel, 2515 Prêles (CH); SPRINGER, Simon, 3007 Berne (CH); CURCHOD, Loïc, 1004 Lausanne (CH)
(74) Mandataire: ICB SA

(57) **Abrégé**

La présente invention concerne un procédé de dépôt d'une matière rare en couche mince à la surface d'une pièce d'habillage d'horlogerie ou de bijouterie comportant les étapes suivantes :
- fourniture (100) d'une pièce brute de matière rare,
- façonnement (200) de la pièce brute de matière rare de sorte qu'elle soit adaptée à être utilisée en tant que pièce cible pour une méthode de PVD,
- dépôt (300) de matière de la pièce cible à la surface d'un substrat constitué par une pièce d'habillage d'horlogerie ou de bijouterie par procédé PVD de sorte à recouvrir ladite pièce d'habillage.

## Description

### Domaine technique de l'invention

L'invention relève du domaine de l'horlogerie et de la bijouterie.

Plus particulièrement, l'invention concerne un procédé de dépôt d'une matière rare en couche mince sur une pièce d'habillage d'horlogerie ou de bijouterie et une pièce d'horlogerie ou de bijouterie obtenue par ce procédé.

Les termes « matière rare » désignent, dans le présent texte, toute matière très rare, voire unique, par sa provenance, son histoire, sa composition, etc. qui présente notamment de ce fait une grande valeur pécuniaire et/ou émotionnelle.

Par exemple, des matières rares au sens de la présente invention peuvent être des matières d'origine extraterrestre, par exemple issues de météorites ou d'échantillons récoltés lors de missions spatiales, des matières issues de reliques, de lieux ou d'objets liés à une histoire particulière, par exemple, des fragments d'épaves de navires ou de fusées spatiales, des objets ayant appartenu à des personnalités historiques, etc.

### Arrière-plan technologique

Dans le domaine de l'horlogerie et de la bijouterie, il est courant d'utiliser des matériaux nobles et des matières rares pour remplir des fonctions décoratives.

On entend par « matériaux nobles », dans le présent texte, tout matériau précieux, par exemple des métaux précieux, tels que l'or ou l'argent.

Par exemple, dans le domaine de l'horlogerie ou de la bijouterie, il est connu d'intégrer des inserts dans des pièces d'habillage, telles que des éléments du bracelet ou du boitier d'une montre, ou de la pièce de bijouterie, ou de réaliser entièrement ces pièces d'habillage dans des matériaux nobles et matières rares.

Plus spécifiquement, il est connu d'intégrer des matières rares comme des morceaux de météorites ou d'épaves sous des formes d'éléments plus ou moins grands dans le cadran, la lunette ou la carrure d'une montre.

Ces morceaux sont prélevés, par exemple sous forme de tranches plus ou moins fines, dans une pièce originale, brute, de matière rare et mis en forme de sorte à correspondre aux dimensions d'un insert ou de la pièce d'habillage qu'ils sont destinés à former. Plus spécifiquement, ces morceaux sont généralement prélevés, puis mis en forme par usinage mécanique.

Avec l'utilisation de ces méthodes de prélèvement et de mise en forme, l'aspect original de la matière rare est généralement préservé, mais une grande quantité de matière de la pièce originale est consommée. En particulier, ces méthodes de prélèvement et de mise en forme induisent la génération de copeaux et de chutes de la matière rare qui ne répond pas aux exigences de taille et/ou d'aspect esthétique lui permettant d'être employée en tant qu'insert dans des pièces d'habillage ou en tant que pièce d'habillage.

Les pièces originales de matière rare étant par définition très rares et onéreuses, on comprend le besoin de limiter au maximum ces pertes de matière.

En outre, l'intégration de matière rare à la surface de pièces d'habillage pose généralement des problèmes de tenue mécanique de l'assemblage dans le temps. Les horlogers sont donc souvent contraints d'ajouter des pattes de fixation ou autres éléments mécaniques pour maintenir la matière rare en position sur les pièces d'habillage, ce qui est susceptible d'impacter la fiabilité, l'aspect esthétique, le poids et le coût de fabrication de la pièce d'horlogerie ou de bijouterie intégrant une telle pièce d'habillage.

### Résumé de l'invention

L'invention résout les inconvénients précités en proposant une solution permettant de recouvrir de matière rare, voire unique, une pièce d'habillage d'horlogerie ou de bijouterie tout en évitant, ou limitant considérablement, les pertes de ladite matière rare lors de la fabrication de ladite pièce d'habillage.

Un des principaux avantages de la présente invention est l'économie de la matière rare qu'elle permet, dans la mesure où la quantité de matière rare consommée correspond sensiblement à la quantité nécessaire pour recouvrir la pièce d'habillage.

Il y a lieu de noter que la présente invention n'a pas pour but de restituer un aspect esthétique fidèle à celui de la pièce originale de matière rare, mais qu'il vise à employer l'ensemble, ou une grande part, des atomes de la pièce de matière rare de sorte à éliminer, ou réduire fortement, les pertes de ladite pièce.

A cet effet, la présente invention concerne un procédé de dépôt d'une matière rare en couche mince à la surface d'une pièce d'habillage d'horlogerie ou de bijouterie comportant les étapes suivantes :
- fourniture d'une pièce brute de matière rare choisie parmi des matières d'origine extraterrestre, par exemple issues de météorites ou d'échantillons récoltés lors de missions spatiales, des matières issues de reliques, de matériaux rares issus de lieux ou d'objets liés à une histoire particulière, par exemple, des fragments d'épaves de navires ou de fusées spatiales, des objets ayant appartenus à des personnalités historiques ;
- façonnement de la pièce brute de matière rare de sorte à obtenir une pièce cible exploitable par une méthode de dépôt physique en phase vapeur, notamment par pulvérisation cathodique ;
- dépôt de matière de la pièce cible sur la surface d'un substrat constitué par une pièce d'habillage d'horlogerie ou de bijouterie par la mise en œuvre d'une méthode de dépôt physique en phase vapeur, notamment par pulvérisation cathodique de ladite cible, de sorte à recouvrir la surface de ladite pièce d'habillage.

Un des principaux avantages de ce procédé réside dans le fait que l'on peut réutiliser la matière rare constituant la pièce cible une fois le procédé achevé, dans la production d'une nouvelle pièce. De la sorte, une économie substantielle de matière rare est réalisée. Ainsi, le coût unitaire de fabrication des pièces d'habillage d'horlogerie ou de bijouterie est considérablement réduit.

De plus, très peu de matière rare est nécessaire pour recouvrir la pièce d'habillage. Par ailleurs, il est possible, grâce au procédé selon l'invention, d'exploiter tout résidu ou toute chute de matière rare, ce qui participe encore à diminuer le coût unitaire de fabrication des pièces d'habillage d'horlogerie ou de bijouterie.

En effet, ces résidus ou chutes de matière rare peuvent être, suivant leur nature, fondus, pulvérisés ou compressés et être façonnés pour obtenir une nouvelle pièce cible.

Ces caractéristiques rendent ainsi possible la production industrielle de petites ou moyennes séries de pièces d'horlogerie ou de bijouterie incluant de la matière rare, alors que dans l'état actuel de la technique la production était fabriquée unitairement de façon artisanale.

En outre, le procédé selon l'invention permet d'assurer une excellente tenue mécanique de la matière rare sur la pièce d'habillage, contrairement aux solutions de l'état de la technique.

Par ailleurs, les méthodes de dépôt physique en phase vapeur présentent l'avantage d'être efficaces sans connaitre la composition exacte de la pièce cible, et donc de la matière rare, ce qui est souvent le cas lorsque celle-ci n'est pas analysée à cet effet.

Enfin, la composition chimique de la couche mince est représentative de celle de la pièce cible, de même que son homogénéité.

Dans des modes particuliers de mise en œuvre, l'invention peut comporter en outre l'une ou plusieurs des caractéristiques suivantes, prises isolément ou selon toutes les combinaisons techniquement possibles.

Dans des modes particuliers de mise en œuvre, l'étape de façonnement consiste à conformer la pièce cible sous forme de disque ou sous la forme d'un matériau pulvérulent, c'est-à-dire un matériau sous forme de poudre, ou sous la forme de granules.

Dans des modes particuliers de mise en œuvre, la matière rare est associée à au moins un autre matériau, dit « matériau auxiliaire » de sorte que la couche déposée sur la pièce d'habillage d'horlogerie ou de bijouterie résulte de la combinaison de ladite matière rare et de l'au moins un matériau auxiliaire.

Dans des modes particuliers de réalisation, le matériau auxiliaire est choisi parmi l'or, l'argent, le platine, le palladium, le rhodium, ou un alliage d'un ou plusieurs de ces métaux, ou une céramique ou un cristal.

Dans des modes particuliers de mise en œuvre, l'étape de façonnement comprend une opération de façonnement d'au moins une deuxième pièce cible réalisée dans le matériau auxiliaire, et avec laquelle lors de l'étape de dépôt, on réalise simultanément le dépôt de matière rare et du matériau auxiliaire sur la pièce d'habillage d'horlogerie ou de bijouterie.

Dans des modes particuliers de mise en œuvre, l'étape de façonnement comporte une opération de conformation du matériau auxiliaire dans la forme d'un disque comportant une pluralité de logements recevant en coopération de forme des inserts réalisés dans la matière rare, de sorte à former une unique pièce cible.

Dans des modes particuliers de mise en œuvre, dans l'étape de façonnement, une poudre ou des granulés réalisés dans une matière rare sont intégrés à une matrice réalisée dans le matériau auxiliaire.

Dans des modes particuliers de mise en œuvre, la pièce cible peut avantageusement être façonnée, lors de l'étape de façonnement, par la fixation de particules de poudre, de granulés, de copaux ou autres résidus de matières rare sur une pièce support, par exemple sous forme de disque, réalisée dans la matière auxiliaire, par le biais d'un matériau constitué par exemple par une colle adaptée, telle qu'une colle époxy, ou par de l'indium.

Dans des modes particuliers de mise en œuvre, l'étape de dépôt de matière est réalisée par pulvérisation cathodique.

Dans des modes particuliers de mise en œuvre, l'étape de dépôt de matière est réalisée par une méthode d'évaporation directe, notamment par évaporation thermique ou par bombardement d'un faisceau d'électrons ou de laser.

Dans des modes particuliers de mise en œuvre, le procédé selon l'invention comprend une étape préliminaire de préparation de surface préalablement à l'étape de dépôt de matière de la pièce cible.

Dans des modes particuliers de mise en œuvre, l'étape préliminaire consiste à déposer une sous-couche d'accroche à la surface de pièce d'habillage et/ou à effectuer une structuration de la surface soit pour améliorer l'accroche soit pour simuler la structure de la pièce en matière rare initiale.

Dans des modes particuliers de mise en œuvre, le procédé selon l'invention comprend une étape finale de traitement de la surface de la couche mince déposée après l'étape de dépôt.

Dans des modes particuliers de mise en œuvre, l'étape finale comprend un zaponnage, un dépôt de couche mince transparente par méthode de dépôt physique par phase vapeur, un dépôt de couche mince atomique transparent, ou un dépôt de couche mince transparente par méthode de dépôt chimique en phase vapeur.

Selon un autre objet, la présente invention concerne une pièce d'habillage d'horlogerie ou de bijouterie comportant une couche mince de matière rare déposée par un procédé de dépôt tel que précédemment décrit.

### Brève description des figures

D'autres caractéristiques et avantages de l'invention apparaîtront à la lecture de la description détaillée suivante donnée à titre d'exemple nullement limitatif, en référence aux dessins annexés dans lesquels :

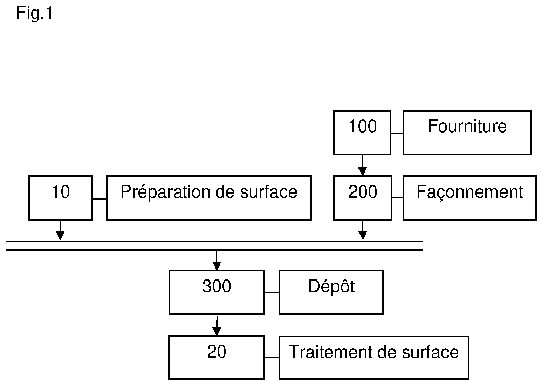

- la figure 1 représente un logigramme illustrant des étapes d'un procédé de dépôt d'une matière rare en couche mince à la surface d'une pièce d'habillage d'horlogerie ou de bijouterie selon un exemple de mise en œuvre de l'invention.

### Description détaillée de l'invention

La présente invention concerne un procédé de dépôt d'une matière rare en couche mince à la surface d'une pièce d'habillage d'horlogerie ou de bijouterie. Avantageusement, la présente invention peut également s'appliquer à tout article de mode, par exemple de lunetterie.

Comme le montre le logigramme de la figure 1, le procédé selon l'invention comporte une première étape de fourniture 100 d'une pièce brute de matière rare, appelée ci-après « brut de matière rare ». Cette étape est suivie d'une étape de façonnement 200 dudit brut de matière rare de sorte qu'elle soit adaptée à être utilisée en tant que pièce cible pour un procédé de dépôt en couche mince par une méthode de dépôt physique en phase vapeur, connu également en langue anglaise sous l'acronyme « PVD » pour « physical vapor deposition ». S'ensuit une étape de dépôt 300 de la matière de la pièce cible façonnée, sur un substrat par une méthode de dépôt physique en phase vapeur, ledit substrat étant constitué dans la présente invention par une pièce d'habillage d'horlogerie ou de bijouterie, mise en œuvre de sorte à recouvrir ladite pièce d'habillage.

La matière rare correspond ici à toute matière très rare, voire unique, du fait notamment de sa provenance, de son histoire, de sa composition, et qui présente notamment de ce fait une grande valeur pécuniaire et/ou émotionnelle. Elle est par exemple choisie, dans la présente invention, selon l'aspect visuel que l'on cherche à obtenir de la pièce d'habillage finie, c'est-à-dire une fois que la couche mince de matière rare est déposée. Par ailleurs, la matière rare peut également être choisie selon les caractéristiques techniques du matériau la constituant afin de conférer certaines propriétés techniques à la pièce d'habillage finie.

Une fois l'étape de fourniture 100 de la matière rare achevée, il est nécessaire de préparer le brut de matière rare, lors de l'étape de façonnement 200, de sorte à obtenir une pièce cible comprenant ladite matière rare pour mettre en œuvre une méthode de dépôt physique en phase vapeur. Une telle méthode de dépôt de couche mince sur substrat est décrite en tant que telle plus loin dans la description.

La réalisation de cette étape de façonnement 200 dépend notamment de la nature du matériau constituant le brut de matière rare.

En particulier, à titre d'exemple non limitatif, si le brut de matière rare fourni est en matériau métallique, par exemple s'il est issu d'un résidu d'une épave, il est avantageux de le façonner de sorte que la pièce cible prenne la forme d'un disque, par exemple de quelques centimètres de rayon et de quelques millimètres d'épaisseur. A cet effet, lors de l'étape de façonnement 200, la pièce cible peut être obtenue par usinage du brut de matière rare, et éventuellement par fonte et moulage si le brut de matière rare fourni est sous la forme d'un ensemble de résidus ou de particules de matière rare, ou encore éventuellement par compression de poudre et frittage.

Les techniques de moulage employées sont adaptées à la nature du brut de matière rare. A titre d'exemple, il est envisageable de réaliser la pièce cible par frittage, par compression, par moulage de coulée de matière en fusion, etc.

Alternativement, si le brut de matière rare est en matériau minéral, par exemple résidu de météorite, il est avantageux que la pièce cible résultant de l'opération de façonnement 200 prenne la forme d'un matériau pulvérulent, par exemple la forme d'une poudre, ou de granulés. A cet effet, lors de l'étape de façonnement 200, le brut de matière rare peut être broyé.

Avantageusement, selon la nature du matériau constituant le brut de matière rare, lors de l'étape de façonnement 200, celui-ci est entièrement broyé, ou bien il est usiné et les copeaux, chutes ou autres résidus sont fondus et moulés pour constituer une pièce cible. On comprend ici que le procédé selon la présente invention permet d'éviter les pertes de matière rare dans la mesure où l'ensemble du brut de matière rare peut être réutilisé pour produire de nouvelles pièces cibles.

Il y a lieu de noter ici que l'étape de façonnement 200 peut également consister à conformer la pièce sous la forme d'un cylindre, d'un fil, ou sous toute autre forme adaptée pour que la pièce cible résultant de cette étape puisse être utilisée dans l'étape de dépôt 300.

De la réalisation de l'étape de façonnement 200 dépend notamment le type de méthode de dépôt de couche mince utilisé lors de l'étape de dépôt 300 dans le procédé selon l'invention. En particulier, selon que la pièce cible soit sous la forme respectivement d'un disque ou d'un matériau pulvérulent ou de granulés, il est préféré des méthodes de dépôt de couche mince respectivement par pulvérisation ou par évaporation.

Plus particulièrement, l'étape de dépôt 300 de matière de la pièce cible, consiste à réaliser dans une chambre de réaction formée par une enceinte fermée dans laquelle l'atmosphère est contrôlée, une opération consistant à vaporiser des atomes de la pièce cible, puis à les entraîner afin qu'ils se déposent sur la surface d'un substrat, en l'occurrence sur la pièce d'habillage, de sorte à former une couche mince de matière rare sur ledit substrat.

Dans une variante de mise en œuvre de l'étape de dépôt 300, la méthode de dépôt de couche mince est réalisée par pulvérisation cathodique ou à arc, par faisceau laser ou par faisceaux d'ions.

Dans la mise en œuvre de la présente invention, la méthode de dépôt de couche mince par pulvérisation cathodique est préférée, dans la mesure où elle permet le dépôt d'une couche mince sur un substrat présentant des formes complexes de façon simple et rapide, potentiellement sans qu'il soit nécessaire de changer la position dudit substrat pour obtenir le dépôt d'une couche mince de façon homogène sur l'ensemble de sa surface.

Cette variante de mise en œuvre est utilisée lorsque la pièce cible est conformée sous la forme d'un disque, avec ou sans matériau auxiliaire tel que défini ci-après.

Dans une autre variante de mise en œuvre de l'étape de dépôt 300, la méthode de dépôt de couche mince est réalisée par évaporation thermique, notamment à basse pression. L'évaporation de la matière rare de la pièce cible est alors obtenue sous vide par effet Joule, par induction de chaleur, par bombardement d'un faisceau d'ions ou d'électrons, par arc électrique ou par faisceau laser.

Cette variante de mise en œuvre est utilisée lorsque la pièce cible est conformée sous la forme d'un disque de dimensions réduites ou sous la forme d'un matériau pulvérulent, c'est-à-dire sous la forme de poudre, ou sous la forme de granules.

Il y a lieu de noter que ces méthodes sont connues en tant que telles par l'homme du métier, et utilisées dans d'autres applications que celle décrite dans le présent texte.

Il peut être particulièrement avantageux que dans le milieu de l'enceinte soit ajouté des gaz réactifs afin de favoriser le dépôt de la couche mince sur la pièce d'habillage.

Dans une variante de mise en œuvre de l'invention, la matière rare est associée à au moins un autre matériau, appelé dans la suite du texte « matériau auxiliaire » de sorte que la couche déposée sur la pièce d'habillage d'horlogerie ou de bijouterie résulte de la combinaison de ladite matière rare et de l'au moins un matériau auxiliaire.

A cet effet, l'étape de façonnement 200 peut comporter une opération de façonnement d'au moins une deuxième pièce cible réalisée dans le matériau auxiliaire, ce dernier étant différent de celui constituant le brut de matière rare.

A titre d'exemple, le matériau auxiliaire peut être un matériau noble tel qu'un métal noble comme l'or, l'argent, le platine, le palladium, le rhodium, ou un alliage d'un ou plusieurs de ces métaux. Le matériau auxiliaire peut également être un matériau céramique ou un cristal.

En outre, dans cette variante de mise en œuvre de l'invention, lors de l'étape de dépôt 300, on réalise simultanément le dépôt de matière rare et de la matière de la au moins deuxième pièce cible sur la pièce d'habillage d'horlogerie ou de bijouterie par la méthode de dépôt physique en phase vapeur, dans une même enceinte.

Avantageusement, le matériau auxiliaire et sa quantité relativement à la quantité de matière rare déposée en couche mince sont choisis selon l'aspect esthétique souhaité et/ou selon les caractéristiques mécaniques souhaitées de ladite couche mince. Les caractéristiques mécaniques désirées sont représentées notamment pars la résistance aux contraintes mécaniques ou à la corrosion de la pièce d'habillage à l'issue du procédé selon l'invention.

Alternativement, dans une autre variante de mise en œuvre du procédé selon l'invention, dans laquelle la matière rare est également associée à au moins un autre matériau, l'étape de façonnement 200 comporte une opération de conformation d'un matériau auxiliaire, dans la forme d'un disque comportant une pluralité de logements. Les logements sont avantageusement prévus pour recevoir en coopération de forme, par exemple par ajustement serré, des inserts réalisés dans la matière rare et fixés dans les logements du disque de matériau auxiliaire par sertissage ou brasage ou collage, de sorte qu'une unique pièce cible est formée par l'agencement particulier de la matière rare et de l'autre matériau.

Les inserts peuvent être composés de matière rare frittée, compressée, moulée, usinée, ou mise en forme par tout autre moyen à la portée de l'homme du métier.

Les logements, et par voie de conséquences, les inserts de matière sont agencés de façon à être répartis régulièrement circulairement. Plus généralement, les logements et inserts sont agencés dans le disque de sorte à correspondre à la piste d'érosion de la pièce cible, aussi connu sous l'appellation en langue anglaise « racetrack » par l'homme du métier.

Encore alternativement, dans l'étape de façonnement 200, une poudre, des granulés, des copeaux ou autres résidus de matière rare peuvent être intégrés à une matrice réalisée dans la matière auxiliaire.

Enfin, encore alternativement, la pièce cible peut avantageusement être façonnée, lors de l'étape de façonnement 200, par la fixation de particules de poudre, de granulés, de copaux ou autres résidus de matière rare sur une pièce support, par exemple sous forme de disque, réalisée dans la matière auxiliaire, par le biais d'un matériau constitué par exemple par une colle adaptée, telle qu'une colle époxy, ou par de l'indium.

Cette caractéristique permet de maximiser l'utilisation de la matière rare lors de l'étape de dépôt 300.

En outre, grâce aux caractéristiques de cette variante de mise en œuvre, il est possible d'économiser encore davantage de matière rare car seulement une faible quantité est nécessaire pour recouvrir en couche mince une pièce d'habillage.

Ainsi, lors de l'étape de dépôt 300, les éléments constitutifs de la pièce cible, c'est-à-dire, la matière rare et le matériau auxiliaire, sont déposés de façon simultanée et se mélangent pour former une couche mince d'un nouveau matériau résultant de ce mélange, à la surface de la pièce d'habillage d'horlogerie ou de bijouterie.

Selon la proportion choisie de matière rare dans la pièce cible, les logements du disque peuvent être de dimensions plus ou moins importantes et/ou les logements peuvent être plus ou moins nombreux dans le disque, de sorte à faire varier la taille des inserts et/ou leur nombre selon la quantité de matière rare désirée dans la couche mince déposée à la surface de la pièce d'habillage.

Il y a lieu de noter que le disque peut être formé en matière rare et les inserts réalisés en matériau auxiliaire, bien que cette solution ne soit pas la plus judicieuse compte tenue du coup du matériau auxiliaire et de celui de la matière rare.

Encore alternativement, lors de l'étape de façonnement 200, la matière rare peut être dopée ou alliée avec des matériaux appropriés, par exemple des métaux ou minéraux, pour lui conférer des caractéristiques techniques souhaitées. La pièce cible est alors, après alliage ou dopage, conformée sous forme de disque.

Par exemple, il est envisageable de fondre une cible à partir d'or fin et d'extraits d'une matière rare issue par exemple d'une pièce en cuivre ou laiton ou bronze provenant d'une épave célèbre, ou de particules minérales provenant d'une météorite ou d'un échantillon prélevé lors d'une mission spatiale, afin de créer une cible en alliage à la fois noble et rare car contenant de la matière provenant de ladite pièce d'épave ou de ladite source extra-terrestre respectivement.

Encore alternativement, lors de l'étape de façonnement 200, la matière rare conformée sous forme pulvérulente, ou de granules, peut être mélangée à une poudre d'un matériau auxiliaire, métallique ou minéral. Ce dernier est choisi pour ses propriétés mécaniques ou pour l'aspect esthétique qu'il peut conférer à la pièce d'habillage une fois l'étape de dépôt 300 réalisée.

Dans une autre variante de réalisation de l'invention, la méthode de dépôt physique en phase vapeur peut également être mise en œuvre dans une atmosphère réactive configurée pour modifier la composition de la couche déposée afin d'augmenter ses propriétés mécaniques et/ou son aspect esthétique.

Par exemple, l'atmosphère peut être configurée de sorte à être oxydante, nitrurante, carburante, ou elle peut être adaptée à doper la matière rare et/ou le matériau auxiliaire.

Le procédé selon la présente invention peut comporter une étape préliminaire 10 de préparation de la surface de la pièce d'habillage d'horlogerie ou de bijouterie par traitement de surface de la pièce d'habillage, préalablement à l'étape de dépôt 300. Cette étape préliminaire 10 peut consister en une texturation de surface à l'échelle micro ou macroscopique, par exemple pour reproduire une structure typique du brut de matière rare, par exemple d'une météorite, et/ou d'améliorer l'accroche, ou par l'activation de la surface par plasma.

Plus particulièrement, il peut être envisagé lors de l'étape préliminaire 10 de déposer une sous-couche d'accroche permettant d'améliorer la fixation de la couche mince à la surface de pièce d'habillage. Par exemple, la sous-couche peut être réalisée en titane, en aluminium ou en chrome, dans le cas où la pièce d'habillage est réalisée dans un matériau céramique.

Le procédé selon la présente invention peut également ou alternativement comporter une étape finale 20 de traitement de la surface de la couche mince déposée, cette étape ayant pour objectif de protéger ladite couche mince de la corrosion ou du ternissement par exemple. A titre d'exemple, l'étape finale 20 comprend un zaponnage, un dépôt de couche mince transparente par méthode de dépôt physique par phase vapeur (connu sous l'acronyme de langue anglaise « PVD », pour « physical vapor deposition »), un dépôt de couche mince atomique transparent par un procédé ALD (pour « atomic layer deposition »), ou un dépôt de couche mince transparente par méthode de dépôt chimique en phase vapeur (connu sous l'acronyme de langue anglaise « CVD », pour « chemical vapor deposition »), etc.

Enfin, un autre objet de la présente invention concerne une pièce d'habillage d'horlogerie ou de bijouterie comportant une couche mince de matière rare déposée par le procédé de dépôt décrit ci-avant.

## Revendications

1. Procédé de dépôt d'une matière rare en couche mince à la surface d'une pièce d'habillage d'horlogerie ou de bijouterie **caractérisé en ce qu'**il comporte les étapes suivantes :
- fourniture (100) d'une pièce brute de matière rare,
- façonnement (200) de la pièce brute de matière rare de sorte à obtenir une pièce cible,
- dépôt (300) de matière de la pièce cible sur la surface d'un substrat constitué par une pièce d'habillage d'horlogerie ou de bijouterie par la mise en œuvre d'une méthode de dépôt physique en phase vapeur, de sorte à recouvrir la surface de ladite pièce d'habillage.

2. Procédé selon la revendication 1, dans lequel l'étape de façonnement (200) consiste à conformer la pièce sous forme de disque, sous la forme d'un matériau pulvérulent ou sous la forme de granules.

3. Procédé selon l'une des revendications 1 ou 2, dans lequel la matière rare est associée à au moins un autre matériau, dit « matériau auxiliaire » de sorte que la couche déposée sur la pièce d'habillage d'horlogerie ou de bijouterie résulte de la combinaison de ladite matière rare et de l'au moins un matériau auxiliaire.

4. Procédé selon la revendication 3, dans lequel le matériau auxiliaire est choisi parmi l'or, l'argent, le platine, le palladium, le rhodium, ou un alliage d'un ou plusieurs de ces métaux, ou une céramique ou un cristal.

5. Procédé selon la revendication 3 ou 4, dans lequel l'étape de façonnement (200) comporte une opération de conformation du matériau auxiliaire dans la forme d'un disque comportant une pluralité de logements recevant en coopération de forme des inserts réalisés dans la matière rare, de sorte à former une unique pièce cible.

6. Procédé selon la revendication 3 ou 4, dans lequel dans l'étape de façonnement (200), une poudre ou des granulés réalisés dans une matière rare sont intégrés à une matrice réalisée dans le matériau auxiliaire.

7. Procédé selon la revendication 3 ou 4, dans lequel lors de l'étape de façonnement (200), la pièce cible est façonnée par la fixation de particules de poudre, de granulés, de copeaux de matière rare sur une pièce support réalisée dans la matière auxiliaire, par le biais d'un matériau constitué par exemple par une colle adaptée ou par de l'indium.

8. Procédé selon l'une des revendications 1 ou 2, dans lequel l'étape de façonnement (200) comprend une opération de façonnement d'au moins une deuxième pièce cible réalisée dans un autre matériau dit « matériau auxiliaire », et dans lequel lors de l'étape de dépôt (300), on réalise simultanément le dépôt de matière rare et du matériau auxiliaire sur la pièce d'habillage d'horlogerie ou de bijouterie.

9. Procédé selon l'une des revendications 1 à 8 dans lequel l'étape de dépôt (300) de matière est réalisée par pulvérisation cathodique.

10. Procédé selon l'une des revendications 1 à 8 dans lequel l'étape de dépôt (300) de matière est réalisée par une méthode d'évaporation directe.

11. Procédé selon l'une des revendications 1 à 10, comprenant une étape préliminaire (10) de préparation de surface préalablement à l'étape de dépôt (300) de matière de la pièce cible.

12. Procédé selon la revendication 11, dans lequel l'étape préliminaire (10) consiste à déposer une sous-couche d'accroche à la surface de pièce d'habillage.

13. Procédé selon la revendication 11, dans lequel l'étape préliminaire (10) consiste à effectuer une structuration de la surface de la pièce d'habillage pour améliorer l'accroche ou pour simuler la structure de la pièce en matière rare initiale.

14. Procédé selon l'une des revendications 1 à 13, comprenant une étape finale (20) de traitement de la surface de la couche mince déposée après l'étape de dépôt (300).

15. Procédé selon la revendication 14, dans lequel l'étape finale (20) comprend un zaponnage, un dépôt de couche mince transparente par méthode de dépôt physique par phase vapeur, un dépôt de couche mince atomique transparent, ou un dépôt de couche mince transparente par méthode de dépôt chimique en phase vapeur.

16. Pièce d'habillage d'horlogerie ou de bijouterie **caractérisée en ce qu'**elle comporte une couche mince de matière rare déposée par un procédé de dépôt selon l'une des revendications 1 à 15.
